# EUROPEAN PATENT APPLICATION

(11) **EP 3 109 958 A1**
(43) Date of publication of application: **28.12.2016**
(21) Application number: 15173098.3
(22) Date of filing: 22.06.2015
(51) Int. Cl.: H02G 1/00, G01R 31/12, H02G 15/064, H02G 15/184

(54) **FIELD CONTROL ELEMENT FOR A HIGH-VOLTAGE CABLE ACCESSORY AND METHOD OF OPTICALLY MEASURING PARTIAL DISCHARGES**

(71) Applicant: Tyco Electronics Raychem GmbH, 85521 Ottobrunn (DE); IPH GmbH, 12681 Berlin (DE)
(72) Inventor: EIGNER, Alexander, 81739 München (DE); KRANZ, Thomas, 81673 München (DE); HEIDMANN, Gerd, 10319 Berlin (DE); VATERRODT, Klaus, 13403 Berlin (DE)
(74) Representative: Grünecker Patent- und Rechtsanwälte PartG mbB

(57) **Abstract**

The present invention relates to a field control element for a high-voltage cable accessory. The present invention further relates to a high-voltage cable accessory (200, 300, 400) and to a method of monitoring partial discharges occurring within an insulating part of such a high-voltage cable accessory. According to the present invention, said field control element (212; 304; 406, 408) comprises an electrically insulating material that is at least partly provided with a fluorescent dye, said fluorescent dye being configured to convert a first radiation generated by an electrical discharge into a second radiation with a wavelength that is longer than the wavelength of the first radiation. A high-voltage cable accessory (200, 300, 400) has an electrically insulating part that comprises at least one field control element (212; 304; 406, 408) according to the present invention and/or and/or a further insulating element comprising a fluorescent dye.

## Description

The present invention relates to a field control element for a high-voltage cable accessory. The present invention further relates to a high-voltage cable accessory and to a method of monitoring partial discharges occurring within an insulating part of such a high-voltage cable accessory.

High-voltage cable accessories are in use for the connection of high-voltage power cables to electrical equipment such as overhead lines, transformers, search arrestors, switchgears etc. They provide the function to either insulate or control the electrical field of power cables at different ambient conditions. High-voltage cable accessories are expected to have a lifetime of more than 40 years without any failure. In order to achieve this requirement, the insulation system and its performance have to be checked regularly. Moreover, due to the fact that a manual installation is always necessary for erecting a termination or installing a cable joint, also faults during the installation have to be considered. Such mistakes can lead to an electrical breakdown with a subsequent arc inside the termination. Consequently, there is a need for a diagnostic method that provides the information about the current status of the cable accessories including their remaining lifetime.

The term "high-voltage" as used in the following is intended to relate to voltages above approximately 1 kV. In particular, the term high-voltage is intended to comprise the usual nominal voltage ranges of power transmission, namely medium voltage (about 3 kV to about 50 kV), high-voltage (about 50 kV to about 110 kV), and also extra high-voltage (up to presently about 500 kV). Of course also higher voltages may be considered in the future. These voltages may be direct current (DC) or alternating current (AC) voltages. In the following, the term "high-voltage cable" is intended to signify a cable that is suitable for carrying electric current of more than about 1 A at a voltage above approximately 1 kV. Accordingly, the term "high-voltage accessory" is intended to signify a device that is suitable for interconnecting high-voltage facilities and/or high-voltage cables. In particular, a high-voltage accessory may either be an end termination or a cable joint.

Today's most commonly used diagnostic method in order to provide real time information about the status and the remaining lifetime of cable accessories is the electrical partial discharge (PD) measurement. Electric discharges that do not completely bridge two electrodes or conductors in close proximity to each other are called partial discharges. The term "partial discharge" as used in the following therefore is intended to describe short term, low-energy and locally limited discharges within an insulation, which do not lead to a complete electric break down, but irreversibly damage the insulation. The term "partial discharge" in particular is intended to comprise so-called "inner partial discharges" which occur within non-gaseous insulating materials. Originating with defects such as cavities or inclusions and interfaces to other materials, in particular to conductors carrying high-voltage, partial discharges lead to the formation of "trees" that grow over time and eventually cause an electric break down. Such PD trees typically have a length of more than 1 µm.

The magnitude of such partial discharges is usually small and the amount of charge transferred is in the range of 10 to a few hundred Pico-Coulombs (pC). For of partial discharge test, a suitably high AC or DC voltage is applied to the conductors surrounding the insulation material under test. Alternatively, the discharge can be detected under normal operating conditions depending on the defect and energized system characteristics.

Today, the most commonly used diagnostic method for obtaining the status of high-voltage cable accessories is the electrical partial discharge measurement according to the IEC standard 60270 ("High-voltage test techniques - Partial discharge measurement", IEC 60270:2000). This setup consists basically of a high-voltage source (which could be based on different techniques such as standard 50 Hz or resonant system), a coupling capacitance for signal extraction and a quadrupole for the adaption of the PD signals for direct measurement. Each partial discharge event causes during the treeing process a short current signal which can be detected with the connected measuring device.

PD diagnostics is therefore based on the measurement of electrical signals with very small amplitude. A disadvantage of this technique is that due to the small amplitude it is very sensitive against electrical noise caused by external electrical fields such as from transformers, overhead lines, etc. Consequently, the electrical partial discharge measurement in a noisy environment (e. g. during on-site tests) does not always allow a proper interpretation of the partial discharge measurement results and thus an understanding of the condition of high-voltage equipment is not possible.

Partial discharges also produce light and therefore it is possible to detect partial discharges by measuring the light generated thereby. Such an optical PD measurement advantageously is not affected by electrical noise from the surrounding high-voltage equipment. For instance by using fiber optic sensors that are integrated into high-voltage accessories, a real time damage monitoring based on an optical PD measurement could be demonstrated. Such a fiber optic sensor arrangement using fluorescent optical fibers is for instance described in the article W. R. Habel et al.: "Fibre-optic sensors for early damage detection in plastic installations of high-voltage facilities", XVII International Symposium on High-voltage Engineering, Hannover, Germany, August 22-26, 2011. A detailed description of this system used with stress cones is also given in the PhD Thesis "Dielectric strength behavior and mechanical properties of transparent insulation materials suitable to optical monitoring of partial discharges" by Chaiyaporn Lothongkam, Fakultät für Elektrotechnik und Informatik der Gottfried Wilhelm Leibniz Universität Hannover, 25.7.2014.

This conventional system, however, suffers from non-satisfactory signal strength in case the partial discharge occurs at a site distanced away from the fluorescent optical fiber. Moreover, only specific fluorescent fiber optic sensors can be used, which have to be mounted as close as possible to the location where the partial discharges have to be detected. In order to achieve a sufficiently high signal yield, this known system needs a large surface of the fluorescent optical fiber to be in contact with the stress cone. Therefore, a long fiber is embedded in an outer region of the stress cone to be arranged helically wound around a longitudinal axis of the stress cone. For mounting the stress cone, however, same normally has to be expanded, sometimes by 400 % of the initial diameter. The optical fiber suffers from the problem that it cannot be expanded in its length to a comparable extent, so that it can be damaged or break during the mounting process.

The object underlying the present invention is to overcome the drawbacks of the existing solutions and to provide a sensitive, accurate and interference tolerant real time monitoring of partial discharges in electrical insulators.

This object is solved by the subject matter of the independent claims. Advantageous embodiments of the present invention are the subject matter of the dependent claims.

Accordingly, the present invention provides a field control element for a high-voltage cable accessory, such as an end termination or cable joint. Moreover, the present invention proposes a corresponding high-voltage cable accessory and a method of monitoring partial discharges occurring within an insulating part of a high-voltage cable accessory.

The present invention is based on the idea that a much easier detection of a partial discharge can be accomplished by performing a wavelength conversion of the primary radiation generated by the PD directly at the site of the discharge. In particular, the present invention proposes to provide an electrically insulating part of the cable accessory itself with a fluorescent dye. Additionally or alternatively, also electrically conducting plastic parts can be provided with a fluorescent dye.

According to the present invention, the fluorescent dye has an absorption spectrum which is in the region of the wavelength emitted by the discharge and a re-emission spectrum that is within the wavelength range that can be detected by a sensor element, such as the photodiode, a photoconductor, a charge-coupled device (CCD), or the like. Most fluorescent dyes exhibit this behavior according to the general physical principle of the so-called Stokes shift. Accordingly, the term "fluorescent dye" in the sense of the present invention is intended to encompasses all substances that are able to absorb radiation in a wavelength range of partial discharges in a medium of interest and to re-emit radiation in a range of longer wavelengths that can be detected by a photodetector.

Introducing the fluorescent dye directly into the insulating part of the high-voltage cable accessory has at least the following advantages: The wavelength of radiation is converted from low wavelengths which are difficult to measure by conventional photodetectors into wavelength ranges where conventional photodetectors exhibit a satisfactory sensitivity. The radiation generated by the partial discharge is directed towards locations where a detecting element can be arranged easily, for instance to the outside of a field control element. Detection elements do not necessarily have to be provided within the insulation material. As the detection principle is based on an optical monitoring, it is not influenced by electrical noise effects.

According to a preferred embodiment, it is the field control element (also called stress cone or stress relief) which is provided at least partly with the fluorescent dye. This is advantageous due to the fact that firstly the stress relief cone is a part fabricated from an essentially insulating material which can easily be modified during its fabrication process by adding a fluorescent dye. The standard production process of conventional high-voltage accessories does not have to be changed fundamentally and existing high-voltage accessories can be retrofitted easily with the system according to the present invention. Furthermore, during operation of the cable, partial discharges often occur at the site of the stress grading elements of a field control element and can therefore be monitored directly. Typically, most of the partial discharges are caused in this area because of improper installation of the stress cone or a bad cable treatment which causes an air entrapment. The arrangement according to the present invention also allows the detection of discharges in other areas, e.g. electrical discharges in oil due to moisture ingress.

The fluorescent dye may comprise any suitable fluorophore that does not impair the insulation or the mechanical performance of the insulation material. Advantageously, the fluorescent dye has an absorption fluorescence between 350 nm and 500 nm, and an emission fluorescence between 500 nm and 800 nm.

As this is known in the art, a fluorophore (or fluorochrome) is a fluorescent chemical compound that can re-emit light upon light excitation. Fluorophores typically contain several combined aromatic groups, or plane or cyclic molecules with several π bonds. Fluorophores can be covalently bonded to a macromolecule, for instance polysiloxane. However, fluorophores may also be used alone, for instance be dispersed in a liquid insulator such as silicone oil.

The fluorophore absorbs light energy of a specific wavelength and re-emits light at a longer wavelength. The absorbed wavelengths, energy transfer efficiency, and time before emission depend on both the fluorophore structure and its chemical environment, as the molecule in its excited state interacts with surrounding molecules. Wavelengths of maximum absorption (approximately corresponding to the excitation wavelength) and emission (for example, Absorption/Emission = 485 nm/517 nm) are the typical terms used to refer to a given fluorophore, but the whole spectrum may be important to consider. The excitation wavelength spectrum may be a very narrow or broader band, or it may be all beyond a cutoff level. The emission spectrum is usually sharper than the excitation spectrum, and it is of a longer wavelength and correspondingly lower energy. Excitation energies range from ultraviolet through the visible spectrum, and emission energies may continue from visible light into the near infrared region. Main characteristics of fluorophores are:
- Maximum excitation and emission wavelength (expressed in nm): corresponds to the peak in the excitation and emission spectra (usually one peak each).
- Extinction coefficient (or molar absorption, in Mol⁻¹cm⁻¹): links the quantity of absorbed light, at a given wavelength, to the concentration of fluorophore in solution.
- Quantum yield: efficiency of the energy transferred from incident light to emitted fluorescence (corresponding to the number of emitted photons per absorbed photons).
- Lifetime (in picoseconds): duration of the excited state of a fluorophore before returning to its ground state. It refers to the time taken for a population of excited fluorophores to decay to 1/e (≈0.368) of the original amount.
- Stokes shift: difference between the maximum excitation and maximum emission wavelengths.

In order to be able to produce sufficiently strong optical signals, preferably at the outside of the field control element, same is at least partly fabricated from a translucent or transparent material. Advantageously, this may be a translucent or transparent polysiloxane.

A field control element according to the present invention may contain a fluorescent dye that is uniformly distributed within at least one translucent or transparent region. Alternatively, also only limited areas or layers may be provided with the fluorescent dye.

According to the present invention, the field control element is formed to be mechanically and optically coupled with optical detection means that are suitable for detecting the second radiation. In particular, the field control element may have one or more openings for introducing an optical fiber. Alternatively, at least one optical fiber for taking up the re-emitted radiation can also be arranged at an outer surface of the field control element. Moreover, it is apparent for a person skilled in the art that also optical transducer elements comprising for instance a photodiode may be arranged in the direct vicinity of the field control element. Furthermore, also autarkic optical detecting means that comprise an optical transducer, signal processing means, an energy harvesting power source, and a wireless communication unit may be used for detecting the re-emitted radiation. Such an autarkic optical detecting means either continuously transmits the information about occurring partial discharging events or stores the measurement data and outputs them only on request from outside.

However, providing at least one optical fiber and a separate optical transducer has the advantage that the optical transducer may be arranged within a protected environment outside the high-voltage cable accessory and is therefore not influenced by electric noise.

Generally, providing an optical fiber for signal transmission has to satisfy the requirement of a void free integration of the fiber in order to avoid that the detection device itself is a source for partial discharges.

For optically coupling the at least one optical fiber to the field control element an additional layer with an optimized reflection behavior can be provided at the interface between the optical fiber and the field control element. Moreover, the optical fiber can be a plastic optical fiber with a refraction index close to the refraction index of the material wherein the fiber is embedded. For enhancing the sensitivity, the optical fiber may also comprise a lens system for focusing the incident light into the fiber.

The particular fluorescent dye that is introduced into the material of the field control element is also depending on the sensitivity of the chosen optical detection means, for instance the photodiode with an optical fiber connected thereto.

The present invention further relates to a high-voltage cable accessory comprising a field control element according to the present invention and/or a further insulating element, for instance a liquid insulating filling or a silicone rubber main body, comprising a fluorescent dye. As already mentioned above, the term "high-voltage cable accessory" according to the present invention signifies a device that is used to connect high-voltage facilities with high-voltage cables or to interconnect high-voltage cables with each other. In particular, a high-voltage cable accessory may be a cable joint or an end termination. It comprises an insulating part that in the mounted state at least partly encompasses the cable insulation. As this is known in the art, the insulating part usually comprises a field control element for controlling the electric field so that an electric field enhancement due to charge accumulation can be avoided. To this end, field control elements comprise areas with a field grading material, which comprises for instance a polymeric matrix and an electrically conducting organic filler. Due to their geometric form, field control elements for high-voltage cable accessories are also often called "stress cones".

As described in detail in the PhD Thesis "Dielectric strength behavior and mechanical properties of transparent insulation materials suitable to optical monitoring of partial discharges" by Chaiyaporn Lothongkam, Fakultät für Elektrotechnik und Informatik der Gottfried Wilhelm Leibniz Universität Hannover, 25.7.2014, such field control elements are at least partly fabricated from a polysiloxane material. Other materials are also used for fabricating field control elements.

The inventors of the present invention made the surprising finding that the materials still fulfill all requirements and perform their required task when introducing a fluorescent dye into the polymeric material. Unexpectedly, it could be shown that a stress cone with a fluorescent dye contained therein can be adapted to have the same satisfactory field grading characteristics and electrical as well as mechanical stability as a stress cone without a fluorescent dye. In particular, the following typical features of the insulating material have to be unimpaired:
- mechanical performance of the insulating material,
- electrical performance (AC, DC and pulses)
- application range and installation behavior.

Depending on the particular installation method, a silicone rubber for instance has to withstand an expansion rate of up to 400% in case of pre-expanded joints. The silicone rubber according to the present invention shows similar performance in this regards and in particular does not split over the whole lifetime. Moreover, the modified field control element has to withstand the typical mechanical forces which are occurring in high-voltage cable accessories. The temperature of the cable conductor can reach 95°C or even 130°C in special situations and consequently creates mechanical forces due to the different thermal expansion of the involved materials. No splitting, no voids or delamination may occur as this would result in immediate failure of the cable accessory. Nevertheless, the mechanical force, i. e. the compression force, of the silicone rubber onto the interface between high-voltage cable accessory and the power cable, has to be in the range which keeps it electrically working during all different electrical stress situations and conditions.

The present invention further provides a method of detecting and/or monitoring partial discharges occurring within an insulating part of a high-voltage cable accessory, wherein said method comprises optically sensing a first radiation generated by an electrical discharge, and further comprises converting said first radiation into a second radiation with a wavelength that is longer than the wavelength of the first radiation by means of a fluorescent dye that is contained in at least a part of said insulating part.

According to the present invention, the fluorescent dye contained in the field control element or another insulating part of a high-voltage cable accessory converts the wavelength of the first radiation generated by a partial discharge into a second radiation with a longer wavelength suitable for being detected for instance by an optical detecting means comprising for instance a photodiode. This conversion step is effected by an adsorption of the first radiation and a re-emission of a radiation with lower energy. The use of such a monitoring system according to the present invention for early damage detection in plastic insulation of high-voltage facilities has at least the following advantages:
- There are no electrical disturbances on the measurement signal.
- There is no influence of corona.
- Additional components such as optical fibers do not necessarily have to be integrated at the most critical locations.
- The complete installation/stress grading material can provide the fluorescent behavior and therefore a light signal can be detected in all the regions of the field control element.
- The installation and also retro-fitting is simple.
- The monitoring system is maintenance free.
- The field control element has the same properties as standard components.
- There is no mechanical decline of the devices.
- The field control element can be fabricated within the standard production process.
- The invention can be used for all voltage classes, AC and DC.

In addition to providing a homogeneously or uniformly distributed filling of the insulating material with a fluorescent dye, of course also only partial areas or layers having fluorescent properties can be provided. Moreover, the method for monitoring partial discharges can of course also be used with other devices than cable accessories.

The accompanying drawings are incorporated into the specification and form a part of the specification to illustrate several embodiments of the present invention. These drawings, together with the description serve to explain the principles of the invention. The drawings are merely for the purpose of illustrating the preferred and alternative examples of how the invention can be made and used, and are not to be construed as limiting the invention to only the illustrated and described embodiments. Furthermore, several aspects of the embodiments may form-individually or in different combinations-solutions according to the present invention. The following described embodiments thus can be considered either alone or in an arbitrary combination thereof. Further features and advantages will become apparent from the following more particular description of the various embodiments of the invention, as illustrated in the accompanying drawings, in which like references refer to like elements, and wherein:
- **FIG. 1**: is a schematic comparison of the wavelength ranges of radiation that is generated by electrical discharges in different media;
- **FIG. 2**: is a schematic representation of the Stokes shift as used by the present invention;
- **FIG. 3**: is a schematic representation of a high-voltage outdoor termination according to the present invention;
- **FIG. 4**: is a schematic representation of another embodiment of a high-voltage outdoor termination;
- **FIG. 5**: is a schematic representation of the plug-in termination according to the present invention;
- **FIG. 6**: is a schematic representation of another embodiment of a plug-in termination;
- **FIG. 7**: is a schematic representation of a cable joint according to the present invention;
- **FIG. 8**: is a schematic representation of another embodiment of a cable joint.

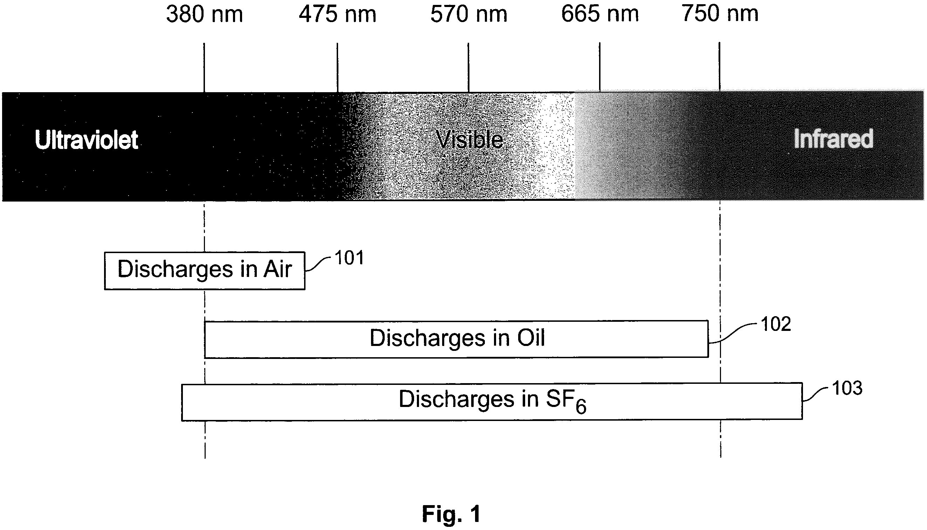

The present invention will now be further explained referring to the Figures, and firstly referring to Figure 1. Figure 1 shows a schematic comparison of the wavelength ranges of radiation that is generated by electrical discharges in different electrically insulating media.

Optical partial discharge detection is based on the detection of the light which is generated as a result of the physical breakdown processes during the electrical discharge. The wavelength of the generated light depends on the insulating material where the discharges occur. Basically it can be differentiated into three main groups which are used in high-voltage engineering: air, oil, and SF₆. The wavelength range 101 for discharges in air is partly in the ultraviolet region and usually below 475 nm. Discharges in oil (symbolized by the bar 102) cause a radiation emission in a wavelength region from about 380 nm to around 750 nm. Furthermore, sulfur hexafluoride (SF₆) is an insulator that is frequently used with switchgear. As shown in Fig. 1, discharges occurring in SF₆ generate radiation in the wavelength range 103 from below 380 nm up to around 800 nm.

Within solid materials most of the discharges are related to air discharges as the void contains air or the failure is often caused by air entrapment. Based on this, the characteristic wavelength of partial discharges in plastic insulations, such as field control elements for high-voltage cable accessories, can be assumed to correspond to the wavelength range 101 of discharges in air.

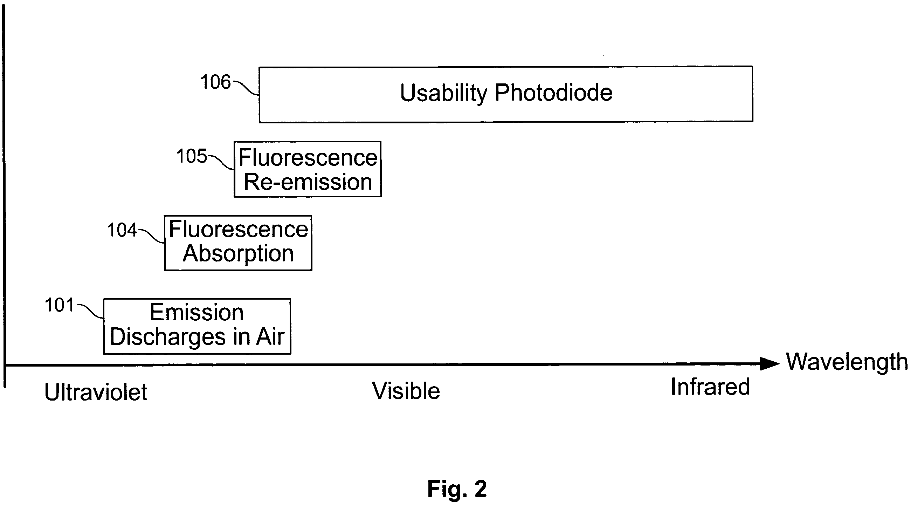

However, a direct real time monitoring of the radiation which is generated by discharges within air is today not possible due to missing affordable equipment for the very short wavelength. As a consequence, the present invention is based on the idea that the wavelength of discharges in air has to be transferred into a range at which such detection can be done in a proper way. Fig. 2 shows the wavelengths of the different steps for optical partial discharge measurement in high voltage cable accessories.

Starting from the wavelength range 101 of the light primarily caused by discharges in air, the light is first absorbed by the fluorescence dye. The adsorption of the chosen fluorescence molecule happens in a wavelength range 104 which is as close as possible to the emission wavelength range 101. Depending on the chosen fluorescence dye, the re-emission of radiation from the excited molecule is of a lower wavelength 105. As already mentioned above, this effect is the well-known Stokes shift exhibited by most fluorescent materials.

When comparing the re-emitted wavelength range 105 with the wavelength range 106 where the photodiode usually is sensitive, it becomes clear that the photodiode is able to detect almost all of the re-emitted radiation in the range 105, but would not be able to detect any of the primarily emitted radiation in the range 101.

According to the present invention, this wavelength conversion step takes place within the bulk material of the insulator, especially within a field control element, by providing a fluorescent dye directly within the material of the insulator. Any fluorescent particles which do not have an influence on the installation performance of the insulation material and have a suitable absorption range 104 and re-emission range 105 can be used according to the present invention.

In particular, when providing a field control element with the fluorescent dye, the emission by the partial discharges can be transformed into radiation with a higher wavelength than directly at the site of the formation of the partial discharge. This lower energy radiation can pass through the insulator material to be detected by an optical detecting means. Advantageously, the re-emitted radiation with its lower energy suffers less damping when travelling through the insulator material than the high-energy primary radiation. This enhances the sensitivity of the monitoring system compared to conventional systems that detect the primary radiation by means of fluorescent optical fibers.

On its way, the re-emitted radiation may be absorbed by other fluorescence dye molecules because the absorption and re-emission spectra 104, 105 overlap. Consequently, the radiation is amplified on its path to the detector and therefore the light yield can be enhanced compared to known systems using fluorescence dye clad optical fibers. As fluorescence re-emission takes place very shortly after the absorption event, no substantial time delay is caused by this additional step (for commonly used fluorescent compounds, typical excited state decay times for photon emissions with energies from the UV to near infrared are within the range of 0.5 to 20 nanoseconds).

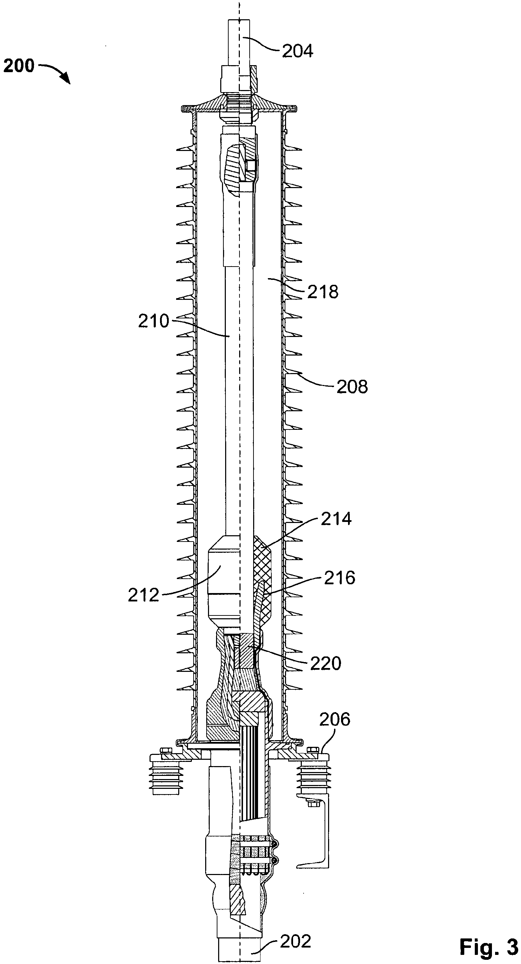

Fig. 3 shows as a first advantageous embodiment of the present invention a high-voltage outdoor termination 200 as commonly used for overhead lines. The termination 200 serves to provide a cable 202 with a cable lug 204 for connecting the cable with high-voltage facilities. Usually this outdoor termination 200 is installed at a base plate 206. A housing 208 which is preferably fabricated from porcelain encloses the inner components and protects them from the surroundings. As generally known in the art, within the housing 208 there is an insulating area 218 which is filled with an electrically insulating filling. The insulating filling may comprise a gas, such as air or SF₆, or a liquid, such as oil. The insulating area 218 is essentially cylindrical and rotation-symmetric.

The high-voltage cable 202 which is inserted into the cable end termination 200 usually is deprived of its outer layers, such as the cable jacket, cushioning layers and the metallic shield. The normally semi-conductive outer cable shield 220 is led on into the area of the field control element 212. Inside the insulating area 218 with the insulating filling, only the cable conductor 210 surrounded by a cable insulation is present.

A field control element 212 (also called stress cone) is provided for controlling the electrical field at the transition between the insulation and the conductive part of the cable. The field control element 212 is arranged at that location within the insulating area 218 where the electrical field stress would be too high for the insulating filling within the insulating area 218. The field control element 212 is formed from an insulating field control body 214 and comprises at least one electrically conductive or semi-conductive deflector 216 for controlling the electrical field as this is known to a person skilled in the art. Typically, the field control element 212 is formed by a transparent or translucent elastomeric field control body 214 with an integrated deflector 216 for influencing the electric field profile within high-voltage devices such as cable accessories. The field control element is usually arranged in the area of the high-voltage accessory where, during operation, the electric field stress is too high for the remaining insulation. The field control element 212 is formed as a cone with an integrated deflector 216 that is formed to deflect the electric field lines by geometric/capacitive effects so that the field strength outside the field control element 212 is reduced to uncritical values.

As shown in Fig. 3, the field control element 212 is formed as a cone with an inner hollow cylindrical opening for receiving the cable 210. This inner hollow cylindrical opening typically is dimensioned to form a press fit between the cable insulation of the cable 210 and the field control element 212. According to the present invention, at least a part of the field control element 212 is provided with a fluorescent dye. Advantageously, the fluorescent dye is provided in the insulating field control body 214 which usually is formed from a polysiloxane elastomer. According to the present invention, fluorescent particles can be homogeneously distributed within the polysiloxane material. Surprisingly, it could be shown that the use of a fluorescent silicone rubber and also the integration of an optical fiber for the signal transmission did not have any disadvantageous effects on the electrical performance of the stress cone.

Alternatively or additionally, only limited areas or layers may contain a fluorescent dye. Of course, the dye may also be embedded in electrically conductive or semi-conductive plastic parts, provided these parts are sufficiently transparent for the absorbed and re-emitted radiation. Moreover, also the insulating filling of the insulating area 218 may contain a fluorescent dye. In this case the filling comprises electrically insulating oil, such as silicone oil with fluorescent particles dispersed therein. Providing the insulating filling with a fluorescent dye can be done in addition or alternatively to providing the filed control element with a fluorescent dye. Of course, the same or different fluorophores can be used in the solid and the liquid matrix, respectively.

A detection of the occurrence of partial discharges can be achieved by optically detecting the re-emitted radiation by means of at least one photodetector, such as a photodiode, a CCD, or the like. The optical detecting means may be located in the vicinity of the field control element 212, but can also be arranged distanced therefrom, for instance within the insulating area 218.

As already mentioned above, most of the partial discharges are caused in the area of the stress cone, and in particular close to the deflector 216, because of an improper installation of the stress cone or a defective cable treatment which causes air entrapment. But also discharges in other areas can be detected for instance electrical discharges in oil due to moisture ingress into the insulating area 218.

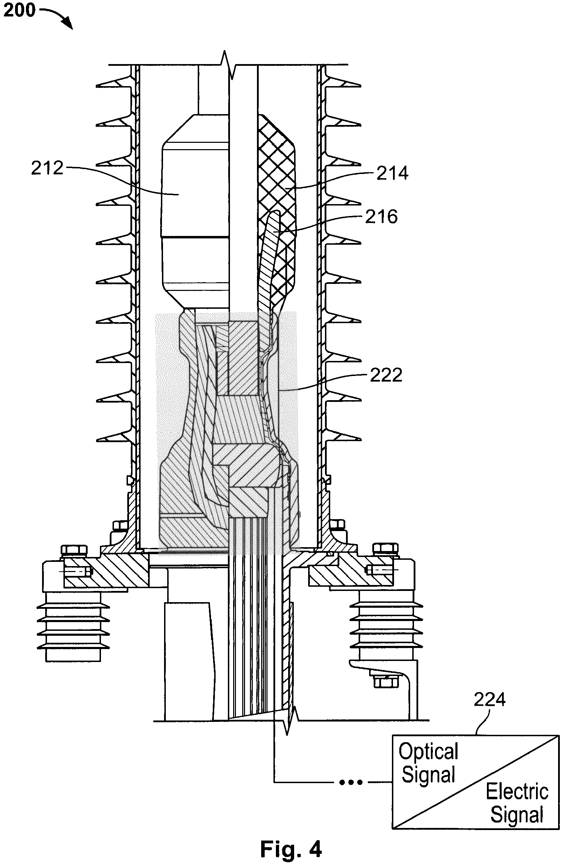

Referring now to Fig. 4, an advantageous embodiment of a high-voltage outdoor termination 200 with an integrated optical detecting means for detecting the re-emitted radiation is shown. According to this embodiment, a fluorescent dye is provided in the field control element 212. In particular, the fluorescent particles may be contained in the field control body 214 which may be an electrically insulating polysiloxane. The electrically conductive deflector 216 usually is intransparent and therefore not provided with the fluorescent dye. However, in case the material of the deflector 216 is sufficiently transparent for the adsorbed and re-emitted radiation, the deflector 216 may also comprise fluorescent particles.

According to the embodiment shown in Fig. 4, an optical detecting means comprises an optical fiber 222 which transmits the re-emitted radiation to an optical transducer 224 which is generating an electrical output signal from the optical signal. Such an optical transducer may for instance comprise a photodiode for converting the sensed radiation into an electrical signal. Moreover, the signal generated by the transducer 224 may be further the processed by a central monitoring unit (not shown in the Figures) which may also be configured to monitor the output signals transmitted from a plurality of such transducers 224.

The coupling end of the optical fiber 222 is located close to the deflector 216 because here most of the partial discharges are to be expected. However, it is clear for a person skilled in the art that the position of the coupling end of the optical fiber may be varied arbitrarily. Moreover, also a plurality of optical fibers may be arranged at different positions. For enhancing the amount of radiation taken up by the fiber a lens system (not shown in the Figures) can be provided at the optical fiber 222.

The optical fiber 222 according to the embodiment shown in Fig. 4 can be a polymeric optical fiber (POF) that this inserted into the insulating field control body 214. In order to ensure a similar optical reflection between the stress cone and the polymeric optical fiber 222, a separate layer with an optically optimized reflection behavior can be provided at the interface between the two surfaces. However, it is clear for a person skilled in the art that other optical detecting means, for instance photodetectors that are directly arranged at the stress cone, can also be used. Moreover, the optical fiber 222 may also be arranged at the surface of the stress cone 212 or within the filling of the insulating area 218. Furthermore, also autarkic optical detecting means (not shown in the Figures) that comprise an optical transducer, signal processing means, an energy harvesting power source, and a wireless communication unit may be used for detecting the re-emitted radiation. Such an autarkic optical detecting means either continuously transmits the information about occurring partial discharging events or stores the measurement data and outputs them only on request from outside.

Of course, also more than one optical fiber 222 or a plurality of autarkic optical detectors can be provided at the high-voltage accessory in order to cover all possible areas where partial discharges might occur.

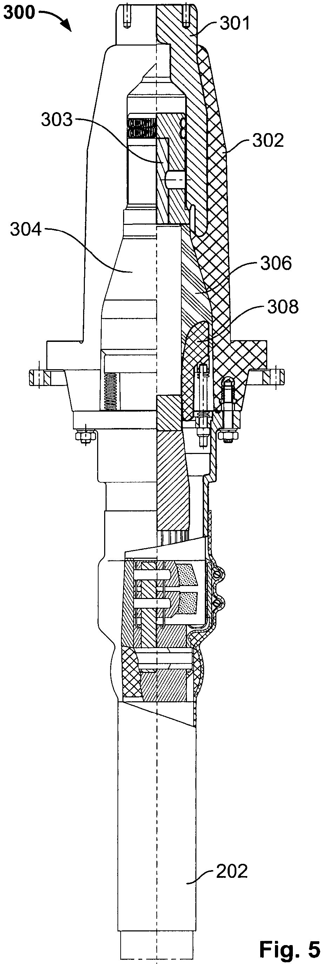

According to a further advantageous embodiment, the principles of the present invention may also be used with switchgear and transformer terminations. Those features which are the same as with Figures 3 and 4 will not be repeated in detail for the sake of brevity. Fig. 5 shows a switchgear termination 300 that is designed to be installed in cable entry housings of gas insulated switchgear. Such a switchgear termination 300 usually operates in SF₆, but also in insulating liquids like transformer oil. As can be seen from Fig. 5, the termination 300 comprises an insulating housing 302 which is for instance formed from a resin. The cable 202 is inserted into the housing with its end being stripped of its outer layers, such as the cable jacket, cushioning layers and the metallic shield. The normally semi-conductive outer cable shield 220 is led on into the area of the field control element 304. Inside the housing 302 there may be provided an additional oil filling which is not shown in the drawing. At the peripheral end, a connector 301 is attached to the conductive core 303 of the cable 202.

The field control element 304 comprises an insulating field control body 306 and a deflector 308. According to the present invention, the field control body 306 is formed from a translucent or transparent polysiloxane which is provided with a fluorescent dye.

As mentioned for the embodiments shown in Figures 3 and 4, the field control element 304 shown in Fig. 5 is arranged in a region of the termination 300 where the highest stress due to the electrical field is to be expected. By providing the field control element 304 with a fluorescent dye, partial discharges can be monitored within the termination 300, preferably by providing an optical detector within or close to the field control element 304. Alternatively or additionally, the fluorescent dye may also be provided in other insulating parts within the housing 302.

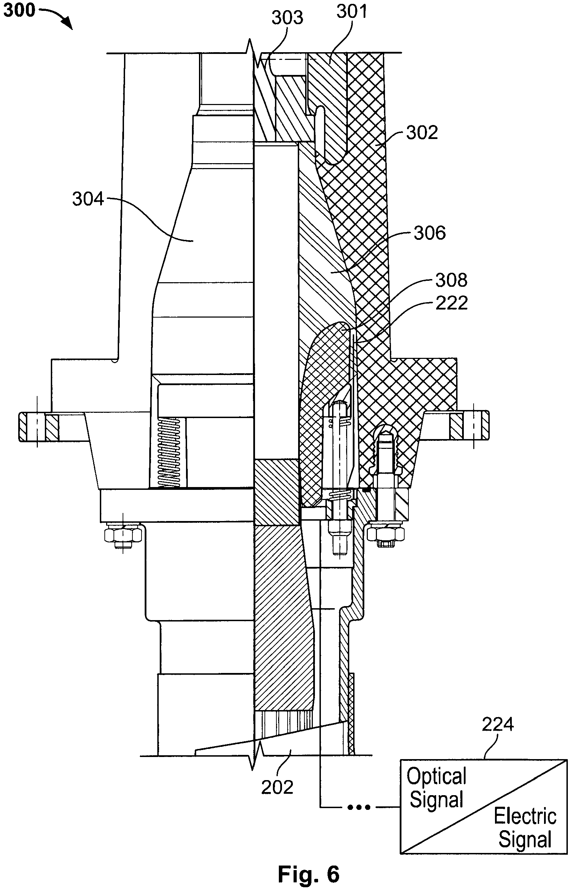

Fig. 6 shows an exemplary embodiment of a switchgear termination 300 having an optical fiber 222 and an optical transducer 224 analogously to the arrangement of Fig. 4. As shown in this Figure, the optical fiber 222 is embedded inside the body 306 of the field control element 304 at a position close to the deflector 308.

In case a partial discharge occurs, light is emitted and this primary radiation is converted by the fluorescent dye in the polysiloxane material into a secondary re-emitted radiation having lower energy and a longer wavelength. The radiation re-emitted by the fluorescence dye partly enters the optical fiber 222 and is transmitted to the optical transducer 224. The transducer 224 converts the optical signal into an electric signal that may be further processed by additional external electronic devices.

Of course, as already mentioned above, the optical fiber 222 may of course be located at any other suitable position and may also be arranged at the outside of the stress cone 304. In particular, it may be helically wound around the stress cone as this is described for fluorescent optical fibers in the above mentioned PhD Thesis "Dielectric strength behavior and mechanical properties of transparent insulation materials suitable to optical monitoring of partial discharges" by Chaiyaporn Lothongkam, Fakultät für Elektrotechnik und Informatik der Gottfried Wilhelm Leibniz Universität Hannover, 25.7.2014 (refer to page 24 of this document).

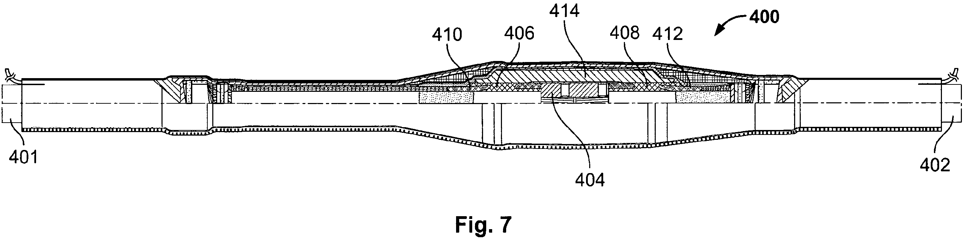

Fig. 7 shows a further advantageous embodiment of the present invention. As shown in this Figure, the principles of the present invention may also be applied to monitor the occurrence of partial discharges in high voltage cable joints 400. Such a cable joint 400 is adapted for connecting two cables 401, 402 with each other. A mechanical connector 404 interconnects the cores of the two cables 401, 402. At each cable, a field control element 406, 408 with deflectors 410, 412 is provided. A silicone rubber main body 414 covers the connection region and may also comprise additional deflecting layers.

According to the present invention, the field control elements 406, 408 as well as the main body 414 may be provided with a fluorescent dye. In an analogous way as explained above with reference to the end terminations, partial discharges that occur inside the cable joint 414 are absorbed by the fluorescent dye. A re-emitted secondary radiation is generated from the primary radiation caused by the PD and can be detected by any suitable optical detecting means.

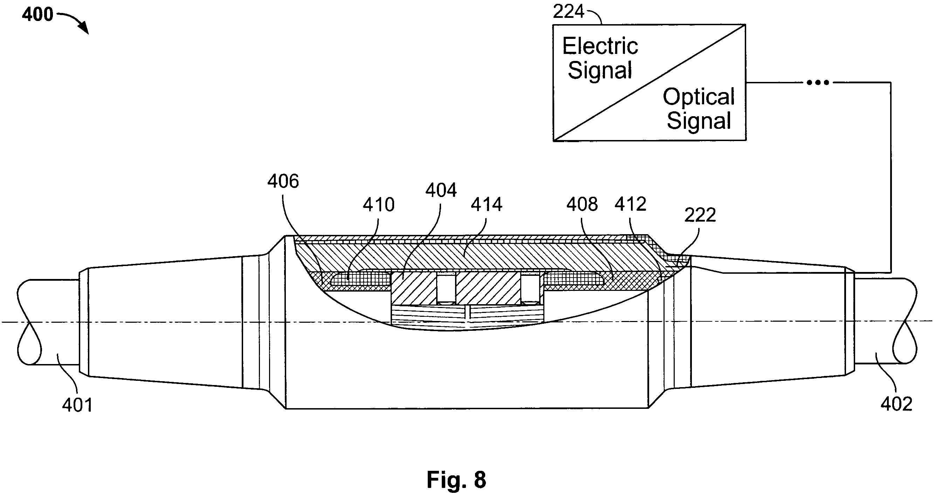

Fig. 8 shows an example where an optical fiber 222 is inserted into the main body 414 for transmitting the re-emitted radiation to the optical transducer 224. The tip of the optical fiber 222 is arranged in the vicinity of the deflector 412 because this is the most critical location regarding the occurrence of partial discharges. However, also partial discharges occurring closer to the mechanical connector 404 will be detected by the optical fiber 222 because the fluorescent radiation will travel through the main body 414 until it is picked up by the optical fiber.

Of course, also the optical transducer 224 of Fig. 8 can be connected to a superordinate electronic unit for further processing the electric signal.

In summary, it could be shown that the integration of optical partial discharge detection on the basis of fluorescent silicone rubber in high voltage cable accessories is possible. During different tests it was verified that the modified silicone rubber has no negative impact due to the fluorescent behavior and can be used for optical partial discharge detection. Synchronous electrical and optical measurements show similar performance. It was also demonstrated that a modified stress cone of a 145 kV termination can fulfill all necessary electrical tests according to IEC 60840. Since the design of the stress cone for higher voltage levels is almost identical, it can be concluded that this technique can also be used for higher voltages and other cable accessories. Consequently, the present invention provides an on-site-PD-measurement with a sensitivity comparable to an electrical partial discharge measurement - but without having the noise issue. Partial discharges can be detected which occur within the fluorescence tagged insulator(s) but also discharges that occur in the optically coupled environment.

**REFERENCE NUMERALS**

| **Reference Numeral** | **Description** |
|---|---|
| 101 | Emission spectrum of discharges in air |
| 102 | Emission spectrum of discharges in oil |
| 103 | Emission spectrum of discharges in SF₆ |
| 104 | Fluorescence absorption spectrum |
| 105 | Fluorescence re-emission spectrum |
| 200 | High-voltage outdoor termination |
| 202 | Cable |
| 204 | Cable lug |
| 206 | Base plate |
| 208 | Housing |
| 210 | Cable conductor |
| 212 | Field control element/stress cone |
| 214 | Field control body |
| 216 | Deflector |
| 218 | Insulating area with insulating filling |
| 220 | Outer cable shield |
| 222 | Optical fiber |
| 224 | Optical transducer |
| 300 | High-voltage switchgear termination |
| 301 | Connector |
| 302 | Resin housing |
| 303 | Conductive core of cable |
| 304 | Field control element |
| 306 | Field control body |
| 308 | Deflector |
| 400 | High-voltage cable joint |
| 401, 402 | Cable |
| 404 | Mechanical connector |
| 406, 408 | Field control element |
| 410, 412 | Deflector |
| 414 | Silicone rubber main body |

## Claims

1. Field control element for a high-voltage cable accessory, wherein said field control element (212; 304; 406, 408) comprises an electrically insulating material that is at least partly provided with a fluorescent dye, said fluorescent dye being configured to convert a first radiation generated by an electrical discharge into a second radiation with a wavelength that is longer than the wavelength of the first radiation.

2. Field control element according to claim 1, wherein said electrically insulating material comprises at least one region of translucent or transparent polysiloxane.

3. Field control element according to claim 1 or 2, wherein said fluorescent dye is homogenously distributed within at least one translucent or transparent region of said field control element (212; 304; 406, 408).

4. Field control element according to one of the preceding claims, said field control element (212; 304; 406, 408) being formed to be mechanically and optically coupled with an optical detecting means (222, 224) for detecting said second radiation.

5. Field control element according to claim 4, wherein said field control element comprises at least one opening for at least partly receiving said optical detecting means (222, 224).

6. Field control element according to one of the preceding claims, wherein a layer with an optical optimized refraction behavior is provided at an interface to said optical detecting means (222, 224).

7. Field control element according to one of the preceding claims, wherein said fluorescent dye comprises a fluorophore that does not impair the insulation or the mechanical performance of the insulating material.

8. High-voltage cable accessory for encompassing a part of at least one cable (202; 401, 402), said high-voltage cable accessory (200, 300, 400) having an electrically insulating part that comprises at least one field control element (212; 304; 406, 408) according to one of the preceding claims and/or a further insulating element (218, 414) comprising a fluorescent dye.

9. High-voltage cable accessory according to claim 8, being formed as an end termination or as a cable joint.

10. Monitoring system for detecting an electrical discharge in a high-voltage cable accessory, said system comprising
at least one high-voltage cable accessory (200, 300, 400) according to one of the claims 8 to 9,
optical detecting means (222, 224) for detecting a radiation with a wavelength that is longer than the wavelength of the first radiation generated by the electrical discharge.

11. Monitoring system according to claim 10, wherein said optical detecting means (222, 224) has a sensing region which is at least partly embedded within the field control element (212; 304; 406, 408) or is arranged at an outer surface of the field control element (212; 304; 406, 408).

12. Monitoring system according to claim 10 or 11, wherein said optical detecting means comprises an optical transducer (224) for generating an electrical signal from the detected radiation and an optical fiber (222) for transmitting said radiation.

13. Monitoring system according to claim 12, wherein said optical transducer (224) comprises a photodiode.

14. Method of detecting and/or monitoring partial discharges occurring within an insulating part of a high-voltage cable accessory (200, 300, 400), wherein said method comprises optically sensing a first radiation generated by an electrical discharge, and further comprises converting said first radiation into a second radiation with a wavelength that is longer than the wavelength of the first radiation by means of a fluorescent dye that is contained in at least a part of said insulating part.

15. Method according to claim 14, wherein said first radiation has a wavelength below 400 nm and wherein said fluorescent dye has an absorption fluorescence between 350 nm and 500 nm, and an emission fluorescence between 500 nm and 800 nm.
